# EUROPEAN PATENT APPLICATION

(11) **EP 1 392 094 A1**
(43) Date of publication of application: **25.02.2004**
(21) Application number: 01934345.8
(22) Date of filing: 25.05.2001
(51) Int. Cl.: H05K 7/14

(54) **SUB RACK AND SUB RACK GUIDE PLATE**

(71) Applicant: MITSUBISHI DENKI KABUSHIKI KAISHA, Tokyo 100-8310 (JP)
(72) Inventor: URESHINO, Michiya, c/o Mitsubishi D.K.K., Chiyoda-ku, Tokyo 100-8310 (JP)
(74) Representative: Sajda, Wolf E., Dipl.-Phys.
(86) International application number: PCT/JP2001/004391
(87) International publication number: WO 2002/098198

(57) **Abstract**

This invention solves difficulty in inserting a package when a guide member deflects downward due to lack of strength of a plurality of guide members divided in a structure of a subrack of integrated type. In a structure of a subrack apparatus 1 of integrated type according to this invention, a guide plate 9 in which a guide rail 9b is provided is divided into a plurality of members in an insertion direction of the package and a reinforcement part 9a in L-shape is provided at an edge for preventing the guide plate 9 from deflecting.

## Description

### Technical Field

This invention relates to a structure of a subrack for inserting a package mounted with an electronic part and accommodating the package in an electronic apparatus.

### Background Art

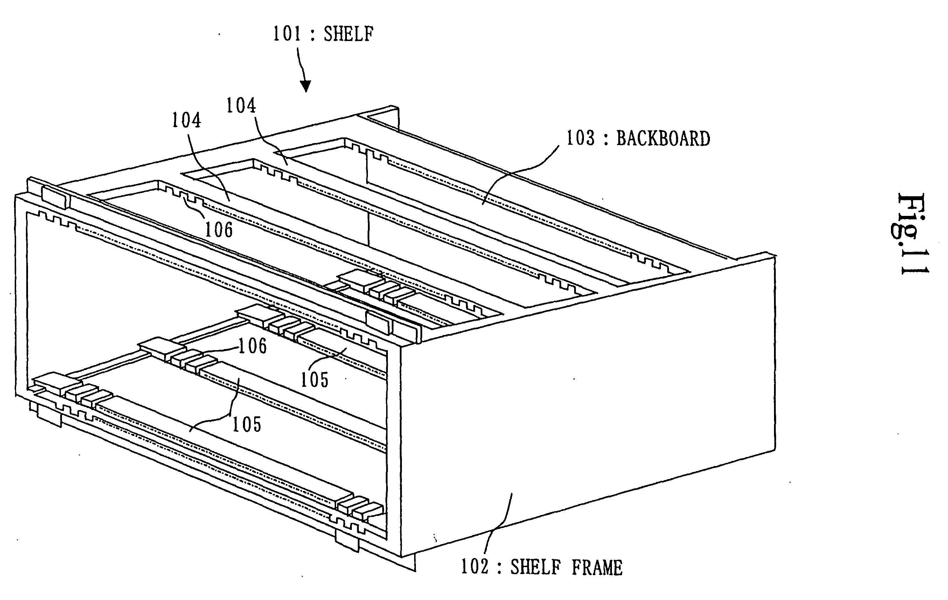

Fig. 11 illustrates a perspective view of an apparatus according to the related art disclosed in Unexamined Published Utility Model Application SHO 64-11596. The apparatus in Fig. 11 includes a shelf 101, a shelf frame 102, a backboard (mother printed-wiring board) 103, guide members 104 and 105 and a guide groove 106.

In Fig. 11, the shelf 101 includes the shelf frame 102 constituting a pair of side walls. The backboard 103 is attached to a back face of the shelf frame 102. In the backboard 103, a connector which is not illustrated is provided, and an electronic circuit package accommodated in the shelf 101 and the backboard 103 are connected electrically by the connector. On an upper face of the shelf frame 102, a plurality of guide members 104 are provided apart each other in a direction perpendicular to an insertion direction of an electronic circuit package. Therefore, an opening for ventilation of a large area is formed between the guide members 104. A plurality of guide grooves 106 is formed on a lower side of the guide member 104. Similarly, on a lower face of the shelf frame 102, a plurality of guide members 105 are provided apart each other in a direction perpendicular to an insertion direction of the electronic circuit package. Therefore, an opening for ventilation of a large area is formed between the guide members 105. A multiplicity of guide grooves 106 is formed on the guide member 105.

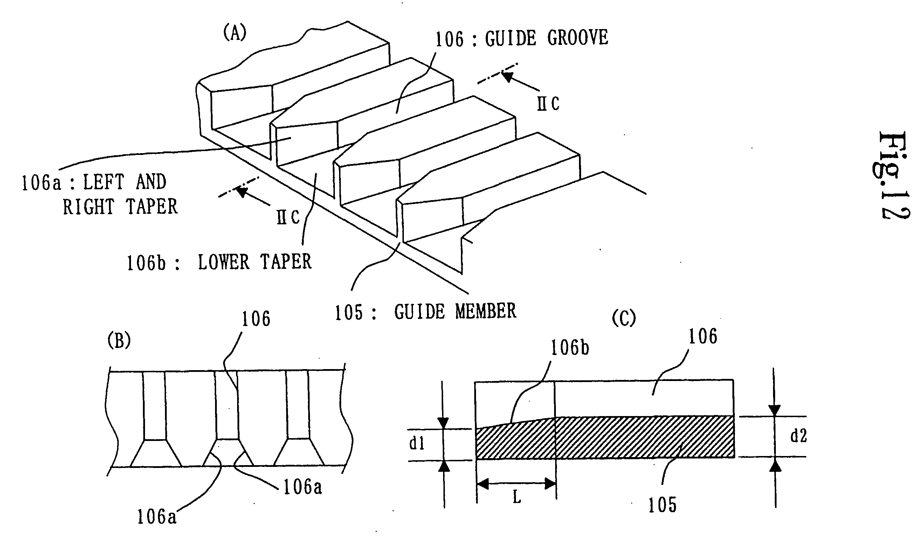

Fig. 12 shows a detailed view of the guide groove of an embodiment illustrated in Fig. 11. (A) is a partially broken perspective view of the guide member 105, (B) is a plane view, and (C) is a sectional view along IIC - IIC line in (A) respectively. In a tip part in an insertion direction of the guide groove 106 formed on the guide member 105, tapers 106a, 106a providing wider space in left and right sides and a taper 106b providing wider space in a lower side are formed. This structure helps improving insertion of the electronic circuit package to the guide groove 106.

As stated, a width of the guide member is narrow in a structure of a shelf of the subrack according to the related art. Therefore, when a multiplicity of packages is inserted, there is a case in which a guide member on a lower side of a center part of the shelf deflects downward, and the package falls down from the guide member on an upper side. Therefore, there was a problem that the guide member had to be reinforced.

Accordingly, this invention is intended to provide an apparatus and a manufacturing method of the apparatus for holding the guide member without deflection due to a weight of an inserted package.

### Disclosure of the Invention

According to this invention, a subrack for inserting a package mounted with an electronic part and accommodating the package in an electronic apparatus includes a plurality of guide plates divided in an insertion direction of the package and placed. The plurality of guide plates includes reinforcement bending parts formed by bending edges created by dividing in the insertion direction of the package.

The plurality of guide plates further includes guide rail parts which form grooves along the insertion direction of the package for guiding insertion of the package.

The guide rail parts are formed by forming openings in the guide plates and bending hems of the openings formed.

The reinforcement bending parts have L-shape.

The plurality of guide plates is placed facing each other to hold the package.

The reinforcement bending parts include a slant part for helping insertion of the package.

The reinforcement bending parts include a slant part for helping insertion of the package.

The subrack further includes a plurality of front rails, placed in a direction perpendicular to an insertion direction of the package, for reinforcing a beginning part of insertion of the package. Each of the plurality of front rails has a different shape.

The guide rail parts have an angle of about 95 degree or more formed between a part provided by bending the hem of the opening and the guide plate.

The reinforcement bending parts include a slant part for helping insertion of the package.

According to this invention, a subrack for inserting a package mounted with an electronic part and accommodating the package in an electronic apparatus includes a guide plate placed in an insertion direction of the package. The guide plate includes an opening and reinforcement bending parts formed by bending edges forming a hem of the opening.

According to this invention, a guide plate of a subrack, placed in parallel with an insertion direction of a package, for inserting the package mounted with an electronic part, includes reinforcement bending parts placed by dividing in an insertion direction of the package and formed by bending edges created by diving in the insertion direction of the package.

### Brief Description of the Drawings

Fig. 1 shows a perspective view illustrating a structure of a subrack of integrated type according to Embodiment 1 of this invention.
Fig. 2 shows a sectional view (arrow A in Fig. 1) illustrating the structure of the subrack of integrated type according to Embodiment 1 of this invention.
Fig. 3 shows a sectional view (arrow B in Fig. 1) illustrating the structure of the subrack of integrated type according to Embodiment 1 of this invention.
Fig. 4 shows a perspective view illustrating a structure of a subrack of integrated type according to Embodiment 2 of this invention.
Fig. 5 shows a sectional view (arrow A in Fig. 1) illustrating the structure of the subrack of integrated type according to Embodiment 2 of this invention.
Fig. 6 shows a perspective view illustrating a structure of a subrack of integrated type according to Embodiment 3 of this invention.
Fig. 7 shows a sectional view (arrow A in Fig. 1) illustrating the structure of the subrack of integrated type according to Embodiment 3 of this invention.
Fig. 8 shows a sectional view (arrow B in Fig. 1) illustrating a structure of a subrack of integrated type according to Embodiment 4 of this invention.
Fig. 9 shows a sectional view (arrow C in Fig. 8) illustrating a guide rail part in the structure of the subrack of integrated type according to Embodiment 4 of this invention.
Fig. 10 shows a sectional view (arrow B in Fig. 1) illustrating a structure of a subrack of integrated type according to Embodiment 5 of this invention.
Fig. 11 shows a perspective view illustrating a structure of a shelf according to the related art.
Fig. 12 shows a detailed view illustrating a guide groove in a structure of the shelf according to the related art.

### Best Mode for Carrying out the Invention

### Embodiment 1.

In the following, Embodiment 1 of this invention is explained with reference to drawings.

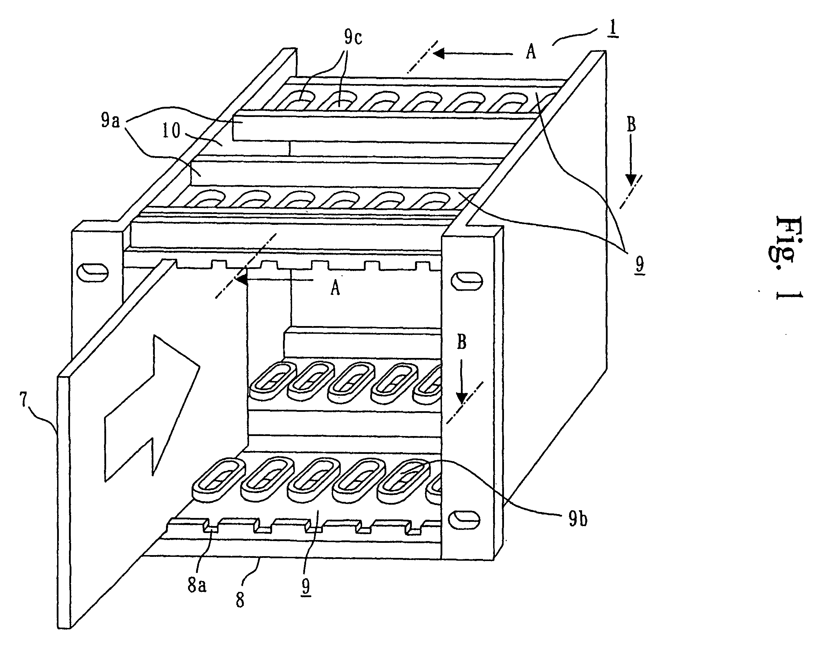

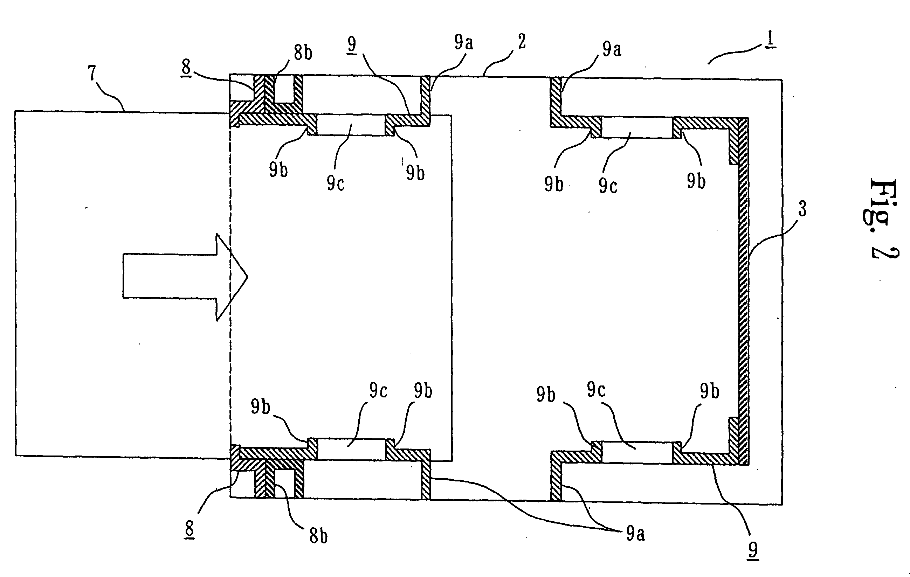

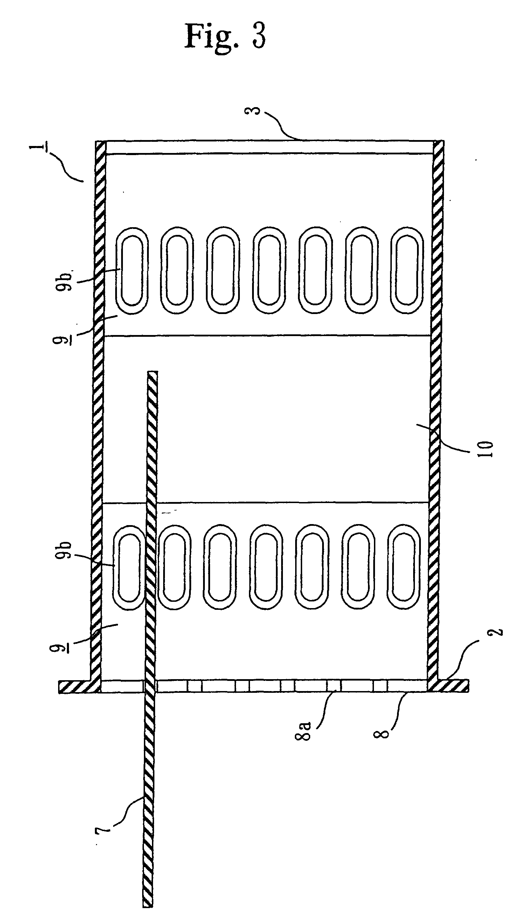

Fig. 1 is a perspective view of a subrack of integrated type in this embodiment. Fig. 2 is a sectional view (sectional view looked from arrow A in Fig. 1) of the subrack of integrated type in this invention. Fig. 3 is a sectional view (sectional view looked from arrow B in Fig. 1) of the subrack of integrated type in this embodiment.

In the following explanation, the subrack of integrated type illustrated in Fig. 1 as an example is used for explanation. However, it is also possible to use a subrack besides the subrack of integrated type. The subrack of integrated type indicates a subrack having a function of inserting a package mounted with an electronic part and a function of accommodating the subrack itself in an electronic apparatus. The subrack indicates a part in general for accommodating the electronic part in the electronic apparatus.

In Figs. 1, 2 and 3, a subrack 1 of integrated type includes a shelf frame 2, a backboard 3, a package 7, a front rail (front rails) 8, a guide plate (guide plates) 9, and a plate opening 10. The shelf frame 2 in Fig. 1 includes a front part bent at a right angle and a screw hole provided in a bent part. The screw hole is used for accommodating the subrack in the electronic apparatus.

A multiplicity of electronic parts, etc. and a connector are mounted in the package 7. The package 7 is also called a printed-circuit board or a substrate. The package 7 can be attached to and removed from the subrack 1 of integrated type.

The front rails 8 include a guide groove (guide grooves) 8a for inserting the package 7 and a reinforcement bending part (reinforcement bending parts) 8b.

The guide plate 9 includes a reinforcement bending part (reinforcement bending parts) 9a and a guide rail part (guide rail parts) 9b for guiding insertion of the package 7. The guide rail part 9b includes an opening (openings) 9c for ventilation.

A plurality of guide plates 9 divided in an insertion direction of the package is placed. The plurality of guide plates is placed apart each other.

The reinforcement bending part 9a is formed by bending an edge (edge forming a hem of the plate opening 10) of the plurality of guide plates divided in the insertion direction of the package and placed. In an example of Fig. 1, the reinforcement bending part 9a has L-shape. However, it is not necessary that it has L-shape. It is also possible to form the reinforcement bending part 9a by bending at a different angle, e.g., obtuse angle.

The guide rail part 9b in oval shape is formed by transforming a part of the guide plate 9. In an example of Fig. 1, the guide rail part 9b forms a groove by bending a plate of the guide plate 9.

The guide rail part 9b is created by creating an opening (corresponding to the opening 9c for ventilation) in the guide plate 9 and bending a hem of the created opening.

The opening 9c for ventilation is a cavity created inside of the guide rail part 9b by providing the guide rail part 9b.

In the guide plate 9, the reinforcement bending part 9a, the guide rail part 9b, and the opening 9c for ventilation are formed by bending an edge of one plate in a structure. In other words, the guide plate 9 illustrated in Fig. 1 does not include a plurality of component parts, but the guide plate 9 includes above elements as an integrated structure. Specifically, the guide plate 9 is formed by bending one seamless material for example. Therefore, the guide plate 9 is connected to the reinforcement bending part 9a and the guide rail part 9b without division.

The plate opening 10 is an opening for ventilation between the guide plates 9.

Next, an operation of inserting the package 7 into the subrack 1 of integrated type is explained.

The package 7 is put in the guide groove 8a of the front rail 8 and inserted on a side of the backboard 3. The package 7 is guided along the guide rail part 9b of the guide plate 9. Further, when the package 7 is continued to be inserted, a connector (not illustrated) of the package 7 and a connector (not illustrated) of the backboard 3 are connected, and the package 7 is accommodated in the subrack 1 of integrated type.

Since the reinforcement bending part 8b of the front rail 8 and the reinforcement bending part 9a in L-shape of the guide plate 9 are included, when and after the package 7 is inserted, it prevents the guide plate 9 from deflecting due to a weight of the package 7 and being deformed by deflection. Further, air passes from a lower side of the subrack 1 of integrated type to an upper side of the subrack 1 of integrated type through the opening 9c for ventilation of the guide rail part 9b and the plate opening 10, and the electronic part mounted in the package 7 is cooled efficiently.

In this embodiment, in a structure of the subrack of integrated type for inserting the package mounted with the electronic part and accommodating the package in the electronic apparatus, explanations are made on the subrack of integrated type in which the guide plate 9 including the guide rail parts 9b is divided into a plurality of members in the insertion direction of the package and placed. The subrack includes the guide plate integrated with the reinforcement bending part in L-shape provided at the edge divided in the insertion direction of the package.

### Embodiment 2.

In the following, Embodiment 2 of this invention is explained with reference to drawings.

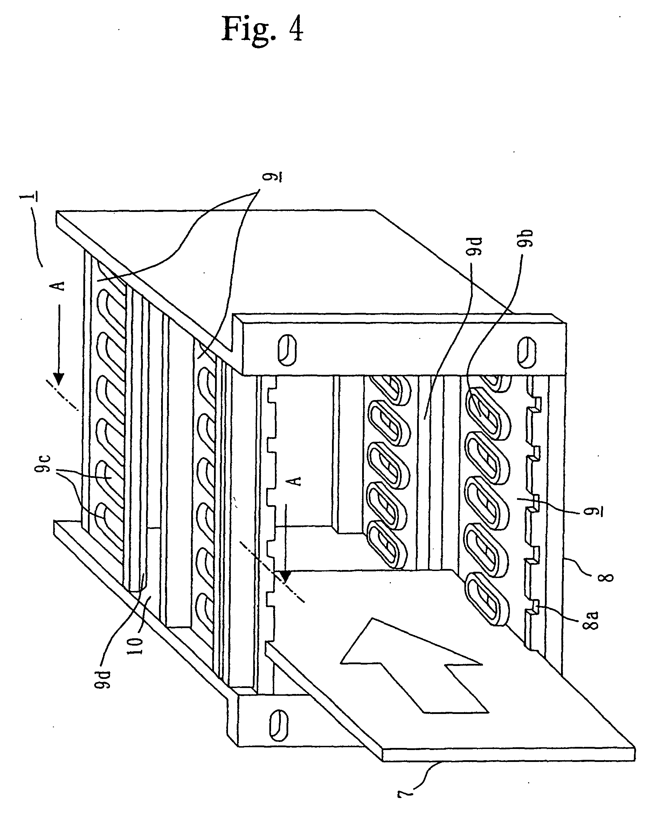

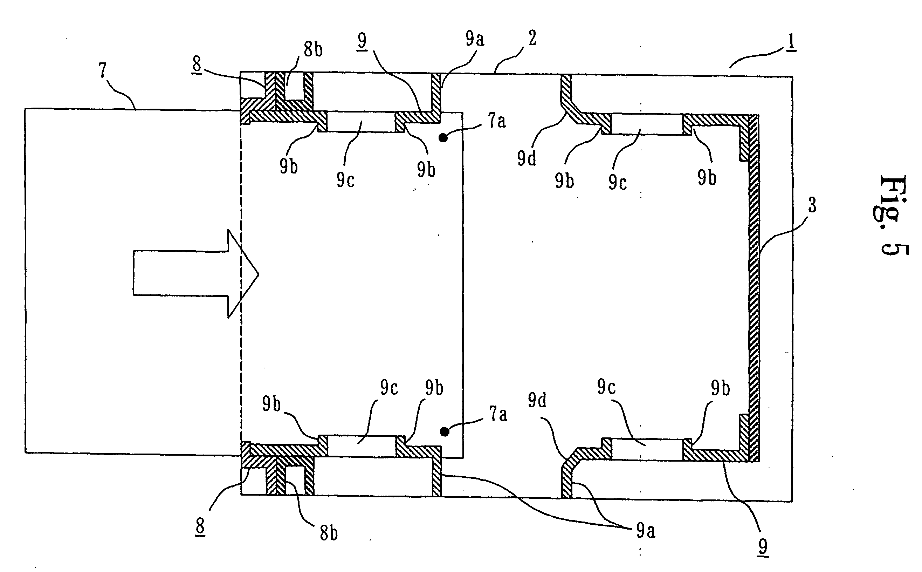

Fig. 4 is a perspective view of the subrack of integrated type in this embodiment. Fig. 5 is a sectional view looked from arrow A of the subrack of integrated type in this embodiment.

In Figs. 4 and 5, upper and lower guide plates 9 placed on a back side of the subrack 1 of integrated type includes a slant part 9d on a front side of the guide plate 9. Hereinafter, the slant part 9d is also called the slant part 9d on the front side of the guide plate 9. The slant part 9d on the front side of the guide plate 9 is a slant part provided on a front plane of the upper and lower guide plates 9 placed on the back side of the subrack of integrated type. The slant part 9d on the front side of the guide plate 9 is formed to be integrated with the reinforcement bending part 9a.

Next, an operation of inserting the package 7 into the subrack 1 of integrated is explained.

As in Embodiment 1 of the invention, the package 7 is put in the guide groove 8a of the front rail 8 and inserted on a side of the backboard 3. The package 7 is guided along the guide rail part 9b. Further, when the package 7 is inserted, since a distance between the guide groove 8a of the front rail 8 in the upper side and the guide groove 8a of the front rail 8 in the lower side is more than a height of the package 7, the package 7 tilts upward or downward. Therefore, the package 7 tilting either upward or downward is inserted on the side of the backboard 3. In such a case, a tip part 7a of the package 7 is guided along the slant part 9d on the front side of the guide plate 9 and surely inserted into the guide rail part 9b. Consequently, the connector (not illustrated) of the package 7 and the connector (not illustrated) of the backboard 3 are surely connected, and a similar effect with Embodiment 1 of the invention can be realized.

### Embodiment 3.

In the following, Embodiment 3 of this invention is explained with reference to drawings.

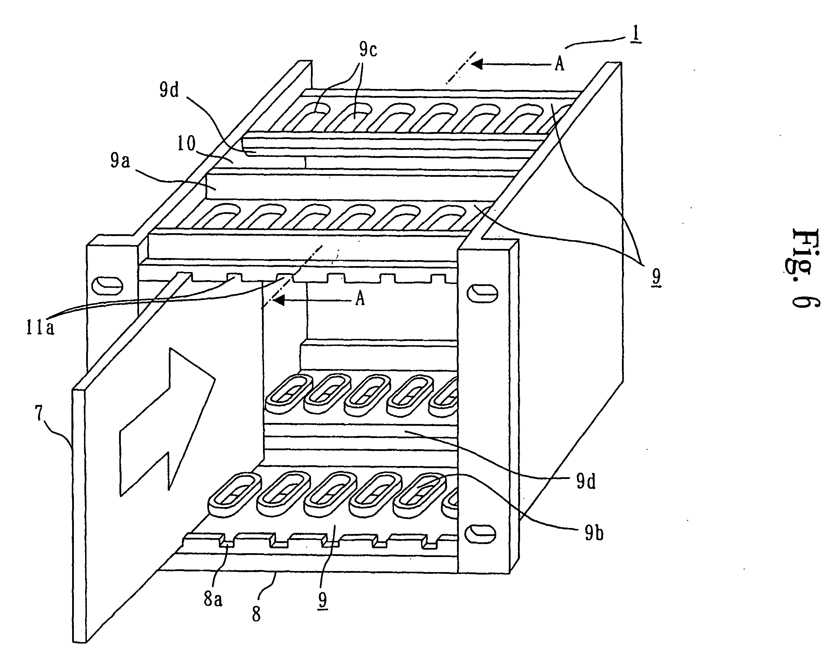

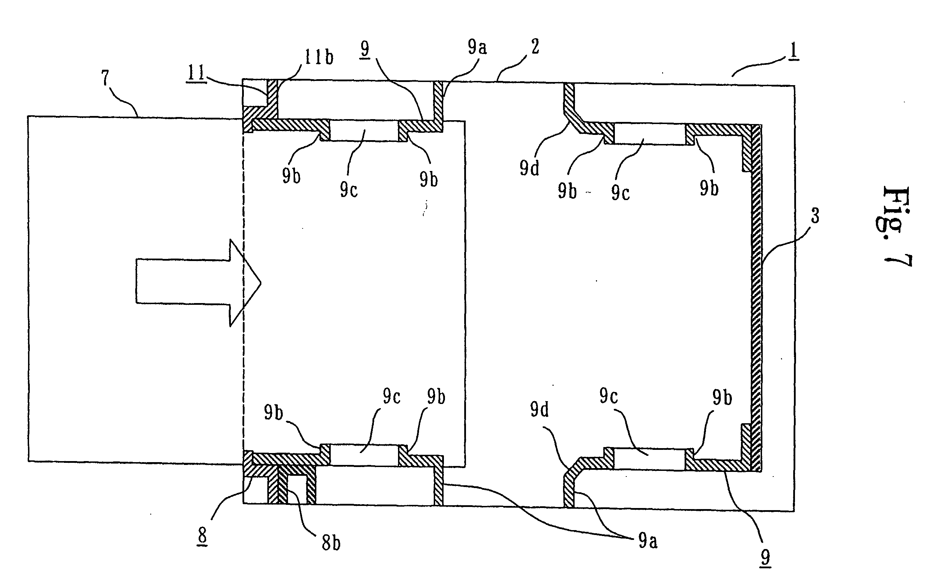

Fig. 6 is a perspective view of the subrack of integrated type of this embodiment. Fig. 7 is a sectional view looked from arrow A of the subrack of integrated type in this embodiment.

In Figs. 6 and 7, a front rail 11 is a front rail provided on a front edge of the guide plate 9 placed on the upper side among the plurality of guide plates provided in the subrack 1 of integrated type. The front rail 11 includes a guide groove 11a for guiding the package 7. The front rail 11 does not include the reinforcement bending part 8b included in the front rail 8 at the front edge of the guide plate 9 placed on the lower side, but the front rail 11 includes a bending part 11b.

Next, an operation of inserting the package 7 into the subrack 1 of integrated type is explained.

As in Embodiment 2 of the invention, the package 7 is put in the guide groove 8a of the front rail 8 and the guide groove 11a of the front rail 11, and inserted on the side of the backboard 3. The package 7 is guided along the guide rail part 9b. Further, when the package 7 is inserted, since a distance between the guide groove 8a of the front rail 8 in the upper side and the guide groove 8a of the front rail 8 in the lower side is more than the height of the package 7, the package 7 tilts upward or downward. The package 7 tilting either upward or downward is inserted on the side of the backboard 3. In such a case, the tip part 7a of the package 7 is guided along the slant part 9d on the front side of the guide plate 9 and surely inserted into the guide rail part 9b. Consequently, the connector (not illustrated) of the package 7 and the connector (not illustrated) of the backboard 3 are surely connected.

Since the reinforcement bending part 8b of the front rail 8 and the reinforcement bending part 9a in L-shape of the guide plate 9 are included, when and after the package 7 is inserted, it prevents the guide plate 9 from deflecting due to a weight of the package 7 and being deformed by deflection. Therefore, even if the front rail of the guide plate 9 in the upper side does not include the reinforcement bending part 8b included in the front rail 8 at the front edge of the guide plate 9 in the lower side, it is possible to maintain sufficient strength of the subrack of integrated type. Accordingly, since the subrack of integrated type can be structured in a simple shape, a number of parts and a number of manufacturing steps can be reduced. Further, a similar effect with Embodiments 1 and 2 of the invention can be realized.

### Embodiment 4.

In the following, Embodiment 4 of this invention is explained with reference to drawings.

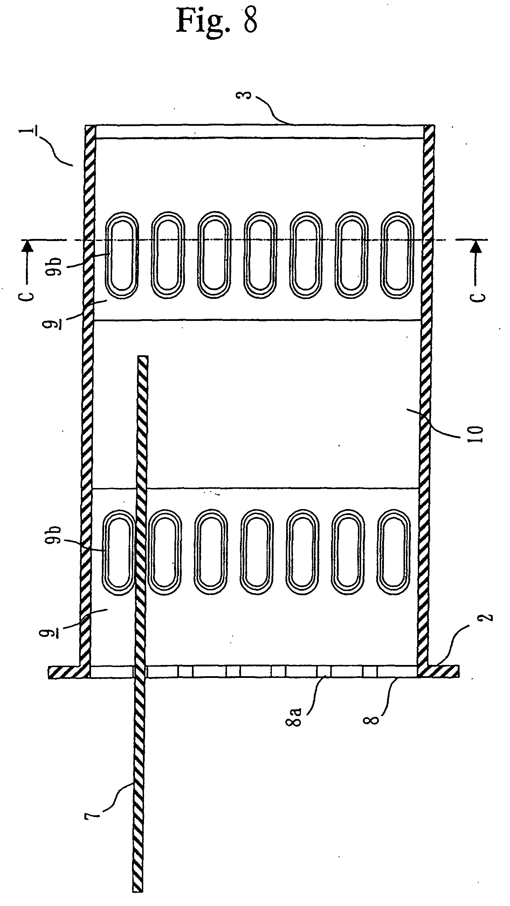

Fig. 8 is a sectional view (looked from arrow B in Fig. 1) of a subrack of integrated type according to this embodiment.

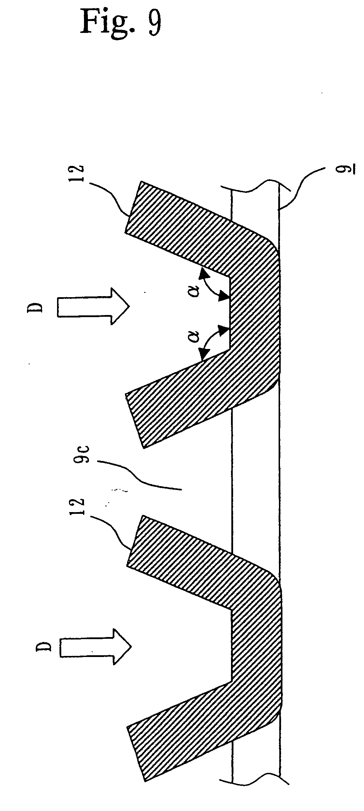

Fig. 9 is a sectional view (a part of a sectional view looked from arrow C in Fig. 8) illustrating an example of a guide rail part 12 in this embodiment. Fig. 9 illustrates two guide rail parts 12.

The guide rail part 9b of the guide plate 9 illustrated in Fig. 1 is formed by bending inward at angle α which is 90 degree from a horizontal plane.

The angle α of bending inward is an angle formed between the guide plate 9 and a bent part of the edge forming the hem of the opening 9c for ventilation of the guide plate 9. The angle α of bending inward is also an angle formed between a plate plane of the guide plate 9 and the guide rail part 9b or an angle formed between a horizontal plane of the guide plate 9 and the guide rail part 9b when the guide rail part 9b is bent inward.

The guide rail part 12 illustrated in Fig. 9 is a guide rail part formed by bending inward at the angle α which is 95 degree or more from the horizontal plane. The package 7 is inserted into a part indicated by arrow D. Practically, the guide plate 9 is often made of metal for improving processing efficiency. The guide rail part 9b is manufactured by drawing the metal. When the angle of bending inward in drawing is 90 degree, a burr is created by drawing. Therefore, deburring drawing is performed for safety. However, when the angle α of bending inward is 95 degree or more (obtuse angle, angle which is about 5 degree or more bigger than 90 degree) as in this embodiment, almost no burr is created by drawing and it is safe. Therefore, deburring processing is not necessary. Consequently, a similar effect with Embodiments 1, 2 and 3 of the invention can be realized while reducing a number of manufacturing steps.

### Embodiment 5.

In this embodiment, a case of forming by a single guide plate in the upper side and the lower side of the subrack of integrated type is explained.

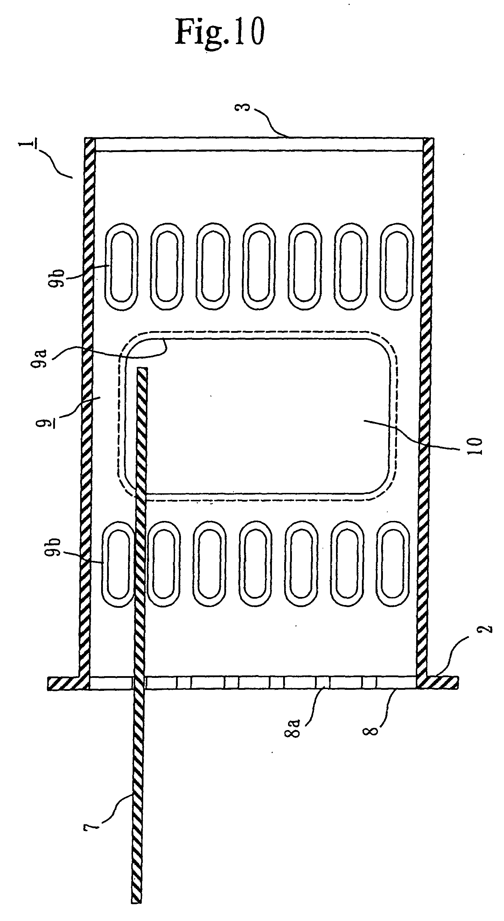

Fig. 10 is a sectional view of the subrack of integrated type in this embodiment. Fig. 10 is a sectional view corresponding to the sectional view of Fig. 3 in Embodiment 1.

In the guide plate 9 illustrated in Fig. 10 as an example, the plate opening 10 is formed in one guide plate 9 and a whole circumference of an edge forming a hem of the formed plate opening 10 is bent and the reinforcement bending part 9a is formed. It is sufficient if the reinforcement bending part 9a is formed to satisfy load tolerance which is necessary for the guide plate 9. It is also possible to form by bending only a p art of the circumference instead of the whole circumference of the edge of the plate opening 10.

Further, a shape of the plate opening 10 can also be a shape, e.g., oval, quadrangle, circle, etc. other than a shape illustrated in Fig. 10.

### Embodiment 6.

The functions explained in Embodiments. 1 - 5 can be provided independently. It is also possible that some or all of the functions are combined.

For example, the subrack of integrated type in Fig. 6 includes the slant part 9d on the front side of the guide plate 9, and the front rail 8 in the upper side and the front rail 8 in the lower side have different shapes. It is also possible that the subrack of integrated type does not include the slant part 9d on the front side of the guide plate 9.

It is also possible to apply the guide rail part 9d of which angle α of bending inward is increased to each of Embodiments. 1, 2, 3 and 5.

### Embodiment 7.

In the above embodiment, a case in which the guide rail part 9b has oval (ellipse, circle including a straight part in a longitudinal direction) shape is illustrated as an example. However, the guide rail part 9b can also have shape, e.g., rectangle (quadrangle) other than this shape. The guide rail part 9b can have a shape other than the above shape as far as satisfying following three conditions: (1) being integrated with the guide plate 9, (2) having a function of guiding the package 7 and (3) having the opening 9c for ventilation.

### Industrial Applicability

As stated, according to Embodiment 1 of this invention, the guide plate in which the guide rail part is provided is divided into a plurality of members in an insertion direction of the package, and the reinforcement part in L-shape is provided at the edge to prevent the guide plate from bending. Therefore, an apparatus with high strength can be produced at a low cost. Further, there is an effect of obtaining an accurate apparatus.

Further, according to Embodiment 2 of this invention, the slant part is provided at a comer of the reinforcement part in L-shape of the guide plate in Embodiment 1. Therefore, in addition to the effect in Embodiment 1, there is an effect of guiding the package surely even if the package tilts upward or downward when the package is inserted.

Further, according to Embodiment 3 of this invention, the upper front rail and the lower front rail in Embodiments 1 and 2 are modified to have different shapes. Therefore, there is an effect of reducing a number of the parts and a number of processing steps.

Further, according to Embodiment 4 of this invention, the angle α of bending inward of the guide rail part in Embodiments 1, 2 and 3 is changed to 95 degree or more from the horizontal plane of the guide plate. Therefore, there is an effect of reducing a number of processing steps.

## Claims

1. A subrack for inserting a package mounted with an electronic part and accommodating the package in an electronic apparatus, the subrack comprising a plurality of guide plates divided in an insertion direction of the package and placed, wherein the plurality of guide plates includes reinforcement bending parts formed by bending edges created by dividing in the insertion direction of the package.

2. The subrack of Claim 1, wherein the plurality of guide plates further includes guide rail parts which form grooves along the insertion direction of the package for guiding insertion of the package.

3. The subrack of Claim 2, wherein the guide rail parts are formed by forming openings in the guide plates and bending hems of the openings formed.

4. The subrack of Claim 1, wherein the reinforcement bending parts have L-shape.

5. The subrack of Claim 1, wherein the plurality of guide plates is placed facing each other to hold the package.

6. The subrack of Claim 1, wherein the reinforcement bending parts include a slant part for helping insertion of the package.

7. The subrack of Claim 3, wherein the reinforcement bending parts include a slant part for helping insertion of the package.

8. The subrack of Claim 1, further comprising a plurality of front rails, placed in a direction perpendicular to an insertion direction of the package, for reinforcing a beginning part of insertion of the package, wherein each of the plurality of front rails has a different shape.

9. The subrack of Claim 3, wherein the guide rail parts have an angle of about 95 degree or more formed between a part provided by bending the hem of the opening and the guide plate.

10. The subrack of Claim 9, wherein the reinforcement bending parts include a slant part for helping insertion of the package.

11. Asubrack for inserting a package mounted with an electronic part and accommodating the package in an electronic apparatus, the subrack comprising a guide plate placed in an insertion direction of the package, wherein the guide plate includes an opening and reinforcement bending parts formed by bending edges forming a hem of the opening.

12. A guide plate of a subrack, placed in parallel with an insertion direction of a package, for inserting the package mounted with an electronic part, the guide plate of the subrack comprising reinforcement bending parts placed by dividing in an insertion direction of the package, and formed by bending edges created by diving in the insertion direction of the package.
